# EUROPEAN PATENT APPLICATION

(11) **EP 4 471 836 A1**
(43) Date of publication of application: **04.12.2024**
(21) Application number: 23743401.4
(22) Date of filing: 10.01.2023
(51) Int. Cl.: H01L 21/67, H01L 21/677

(54) **HIGH-PRESSURE WAFER PROCESSING METHOD USING DUAL HIGH-PRESSURE WAFER PROCESSING FACILITY**

(30) Priority: 24.01.2022 KR 20220009706
(71) Applicant: HPSP Co., Ltd., Hwaseong-si, Gyeonggi-do 18449 (KR)
(72) Inventor: CHO, Sung Kil, Yongin-si, Gyeonggi-do 16995 (KR)
(74) Representative: von Bülow & Tamada
(86) International application number: PCT/KR2023/000428
(87) International publication number: WO 2023/140552

(57) **Abstract**

The present invention provides a high-pressure wafer processing method using a dual high-pressure wafer processing facility, the method comprising the steps of: disposing a wafer in a first processing chamber of a first high-pressure wafer processing module; performing a first process, which corresponds to one among high-pressure oxidation, high-pressure nitridation, high-pressure carbon doping, and high-pressure heat treatment, on the wafer in the first processing chamber; transferring the wafer to a second processing chamber of a second high-pressure wafer processing module; and performing a second process, which corresponds to another among the high-pressure oxidation, the high-pressure nitridation, the high-pressure carbon doping, and the high-pressure heat treatment, on the wafer in the second processing chamber.

## Description

### [Technical Field]

The present invention relates to a high-pressure wafer processing method using a dual high-pressure wafer processing facility.

### [Background Art]

In general, a semiconductor manufacturing process may be largely classified into a pre-process and a post-process. The pre-process may include oxidation, deposition, exposure, etching, ion implantation, wiring, and the like.

An insulation film may be formed on a wafer by the oxidation process or the deposition process. The insulation film may prevent a leakage current from occurring even after a circuit pattern is formed. The insulation film may also serve as a protective film in the subsequent etching process or the like. Therefore, a qualitative property of the insulation film, such as density, is required to be secured to a certain level or above.

However, the insulation film formed by the conventional deposition process or oxidation process may not have a sufficient level of a qualitative property. This phenomenon may also occur in a thin film other than the insulation film.

In addition, when a plurality of processes are performed on the wafer, such as oxidation, nitridation, and annealing, each process may be performed in separate equipment. Accordingly, the wafer may be transferred between the separate equipment, thus causing a longer queue time. During the queue time, the wafer may be exposed to the atmosphere and undergo natural oxidation.

### [Disclosure]

### [Technical Problem]

An object of the present invention is to provide a high-pressure wafer processing method using a dual high-pressure wafer processing facility that improves a qualitative property of a processed wafer while suppressing natural oxidation of the wafer.

### [Technical Solution]

According to an embodiment of the present invention, provided is a high-pressure wafer processing method using a dual high-pressure wafer processing facility, the method including: disposing a wafer in a first processing area of a first high-pressure wafer processing module; performing a first process, which corresponds to one among high-pressure oxidation, high-pressure nitridation, high-pressure carbon doping, and high-pressure annealing, on the wafer in the first processing area; transferring the wafer to a second processing area of a second high-pressure wafer processing module; and performing a second process, which corresponds to another one among the high-pressure oxidation, the high-pressure nitridation, the high-pressure carbon doping, and the high-pressure annealing, on the wafer in the second processing area, wherein the first high-pressure wafer processing module and the second high-pressure wafer processing module are disposed in one accommodation space, the wafer is transferred from the first processing area to the second processing area, in the accommodation space, and the first process and the second process are performed at a reaction pressure higher than an atmospheric pressure.

The reaction pressure of the high-pressure oxidation, the high-pressure nitridation, or the high-pressure carbon doping may be determined within a range of 5 ATM to 20 ATM.

The reaction pressure of the high-pressure annealing may be determined within a range of 3 ATM to 20 ATM.

A reaction temperature of the high-pressure oxidation, the high-pressure nitridation, or the high-pressure annealing may be determined within a range of 400°C to 600°C.

Source gas for each of the high-pressure oxidation and the high-pressure nitridation may include any one of oxygen gas, water vapor, and ammonia gas.

The high-pressure carbon doping may be performed at a reaction temperature below a thermal decomposition temperature of source gas for carbon doping, thus causing the source gas to chemically react with an insulation film of the wafer in its molecular state.

The reaction temperature of the high-pressure carbon doping may be determined within a range of 400°C to 600°C.

The source gas for carbon doping may include any one of ethylene gas and propylene gas.

The method may further include performing the high-pressure annealing on the wafer by using an in-situ method after performing any one of the high-pressure oxidation, the high-pressure nitridation, and the high-pressure carbon doping.

The method may further include performing a purge between any one of the high-pressure oxidation, the high-pressure nitridation, the high-pressure carbon doping, and the high-pressure annealing, wherein the purge is performed while maintaining the reaction pressure and a reaction temperature in a previous process.

Each of the first high-pressure wafer processing module and the second high-pressure wafer processing module may further include a protective area accommodating any one of the first processing area and the second processing area and maintained at a protective pressure, and the protective pressure in the protective area may be adjusted in conjunction with the reaction pressure to be higher than the reaction pressure.

The accommodation space may be maintained at a pressure higher than the atmospheric pressure.

The transferring of the wafer to the second processing area of the second high-pressure wafer processing module may include unloading the wafer from the first processing area and then loading the wafer into the second processing area without a cooling process.

The performing of the second process, which corresponds to another one among the high-pressure oxidation, the high-pressure nitridation, the high-pressure carbon doping, and the high-pressure annealing, on the wafer in the second processing area may include confirming a process condition by considering a queue time after completing the first process.

The first process may be the high-pressure oxidation, the second process may be the high-pressure carbon doping, and the reaction pressure of the high-pressure oxidation and the high-pressure carbon doping may be determined within a range of 5 ATM to 20 ATM.

The second process may further include the high-pressure annealing performed using an in-situ method after the high-pressure carbon doping, and the reaction pressure of the high-pressure annealing may be determined within the range of 5 ATM to 20 ATM.

The first process may be the high-pressure annealing, the second process may be the high-pressure oxidation, and the reaction pressure of the high-pressure annealing and the high-pressure oxidation may be determined within a range of 5 ATM to 20 ATM.

The first process may be the high-pressure annealing, the second process may be the high-pressure nitridation, and the reaction pressure of the high-pressure annealing and the high-pressure nitridation may be determined within a range of 5 ATM to 20 ATM.

The first process may be the high-pressure oxidation, the second process may be the high-pressure annealing, the reaction pressure of the high-pressure oxidation may be determined within a range of 5 ATM to 20 ATM, and the reaction pressure of the high-pressure annealing may be determined within a range of 3 ATM to 20 ATM.

The first process may be the high-pressure nitridation, the second process may be the high-pressure annealing, the reaction pressure of the high-pressure nitridation may be determined within a range of 5 ATM to 20 ATM, and the reaction pressure of the high-pressure annealing may be determined within a range of 10 ATM to 20 ATM.

### [Advantageous Effects]

According to the high-pressure wafer processing method using a dual high-pressure wafer processing facility according to the present invention configured as above, the wafer queue time may rarely occur because the high-pressure first process is performed on the wafer in the first processing area, the wafer is then transferred to the second processing area in the accommodation space, and the high-pressure second process may then be performed on the wafer. It is thus possible to minimize the time the wafer is exposed to the atmosphere, thereby strongly suppressing the natural oxidation of the wafer. In addition, both the first process and the second process may be performed at the high pressure, thereby greatly improving the qualitative property of the processed wafer.

### [Description of Drawings]

FIG. 1 is a conceptual diagram of a dual high-pressure wafer processing facility used to perform a high-pressure wafer processing method according to an embodiment of the present invention.
FIG. 2 is a conceptual diagram more specifically showing a first high-pressure wafer processing module 100 in FIG. 1.
FIG. 3 is a block diagram for describing a control operation of the first high-pressure wafer processing module 100 in FIG. 1.
FIG. 4 is a flowchart showing the high-pressure wafer processing method according to an embodiment of the present invention.
FIG. 5 is a flowchart showing a specific proceeding method of a second process.
FIG. 6 is a flow chart for describing a mechanism of action of high-pressure carbon doping (HPCD).
FIG. 7 is a comparative graph of step coverage of an insulation film manufactured by the high-pressure oxidation (HPO).
FIG. 8 is a comparative graph of a refractive index of the insulation film manufactured by the high-pressure oxidation (HPO) and the high-pressure carbon doping (HPCD).
FIG. 9 is a comparative graph of a dielectric constant of the insulation film manufactured by the high-pressure oxidation (HPO) and the high-pressure carbon doping (HPCD).
FIG. 10 is a comparative graph showing a change in the dielectric constant of the insulation film doped by additionally performing the high-pressure annealing (HPA) thereon.
FIG. 11 is a comparative graph of a hydrogen concentration of a wafer that sequentially undergoes the high-pressure annealing (HPA) and the high-pressure oxidation (HPO).
FIG. 12 is a comparative graph of a hydrogen concentration at an interface, caused by the high-pressure annealing (HPA) and the high-pressure oxidation (HPO).
FIG. 13 is a comparative graph of a hydrogen concentration at the interface, caused by the high-pressure annealing (HPA) and the high-pressure nitridation (HPN).
FIG. 14 is a comparative graph of a wet etch rate of the insulation film by the high-pressure oxidation (HPO) and the high-pressure annealing (HPA).
FIG. 15 is a comparative graph of a nitrogen concentration of a hafnium oxide film by the high-pressure nitridation (HPN).
FIG. 16 is a comparative graph showing a change in the nitrogen concentration of the hafnium oxide film, caused by the high-pressure nitridation (HPN) and the high-pressure annealing (HPA).

### [Best Mode]

Hereinafter, a high-pressure wafer processing method using a dual high-pressure wafer processing facility according to a preferred embodiment of the present invention is described in detail with reference to the attached drawings. Throughout the present invention, components that are the same as or similar to each other are denoted by reference numerals that are the same as or similar to each other even in a different embodiment, and a description thereof is replaced by the first description.

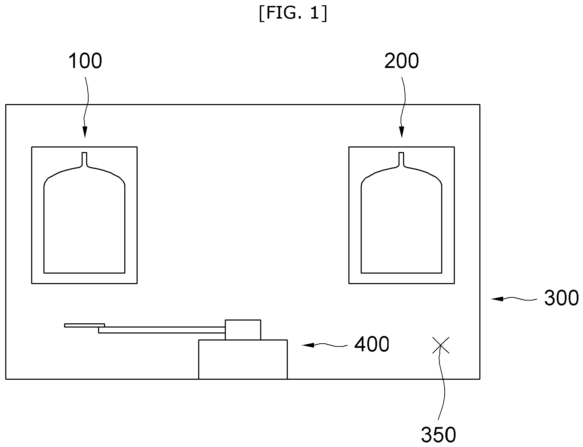

FIG. 1 is a conceptual diagram of a dual high-pressure wafer processing facility used to perform a high-pressure wafer processing method according to an embodiment of the present invention.

Referring to this drawing, the dual high-pressure wafer processing facility may include a first high-pressure wafer processing module 100, a second high-pressure wafer processing module 200, a case 300, and a transfer robot 400.

Each of the first high-pressure wafer processing module 100 and the second high-pressure wafer processing module 200 may be a device performing high-pressure processing on a wafer (not shown). Each of the modules 100 and 200 may perform high-pressure oxidation (HPO), high-pressure nitridation (HPN), high-pressure carbon doping (HPCD), and high-pressure annealing (HPA).

The case 300 may form one accommodation space 350. The modules 100 and 200 may be disposed in the accommodation space 350. When the wafer is transferred from the first high-pressure wafer processing module 100 to the second high-pressure wafer processing module 200, the wafer may be transferred in the accommodation space 350. The accommodation space 350 may be maintained at a pressure slightly higher than an atmospheric pressure. The accommodation space 350 may be filled with air filtered by a fan filter unit (FFU).

The transfer robot 400 may transfer the wafer between the modules 100 and 200. For example, the transfer robot 400 may unload the wafer from the first high-pressure wafer processing module 100 and load the same into the second high-pressure wafer processing module 200.

According to this configuration, the wafer may not be exposed to the atmosphere, and stay only in the accommodation space 350 in a process of loading from the first high-pressure wafer processing module 100 to the second high-pressure wafer processing module 200. The wafer may not need to be disposed in a front opening unified pod (FOUP). Accordingly, the wafer may not require a cooling process to cool to room temperature.

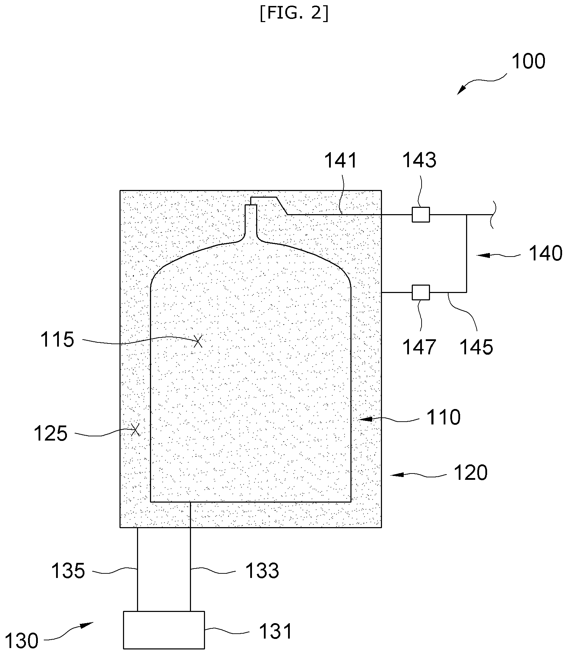

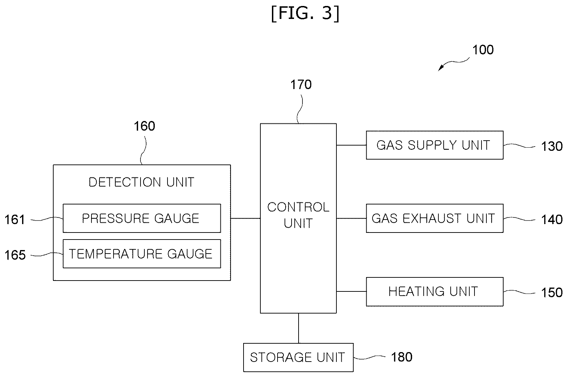

The first high-pressure wafer processing module 100 is described with reference to FIGS. 2 and 3.

FIG. 2 is a conceptual diagram more specifically showing the first high-pressure wafer processing module 100 in FIG. 1.

Referring to this drawing, the first high-pressure wafer processing module 100 may include an internal chamber 110, an external chamber 120, a gas supply unit 130, and a gas exhaust unit 140.

The internal chamber 110 has a processing area 115 for high-pressure processing the wafer. The internal chamber 110 may be made of a non-metallic material, for example, quartz, to reduce a possibility that contaminants (particles) occur in a processing environment. Although simplified in the drawing, a door (not shown) for opening the processing area 115 may be disposed at a lower end of the internal chamber 110. As the door descends, the processing area 115 may be opened, and the wafer may be input into the processing area 115 while being mounted on a holder (not shown). As a heater (not shown) disposed outside the internal chamber 110 is operated, a temperature of the processing area 115 may reach several hundred degrees Celsius. The holder may be a wafer boat capable of stacking the wafers in a plurality of layer. The wafer boat may also be made of a quartz material.

The external chamber 120 may accommodate the internal chamber 110. Unlike the internal chamber 110, the external chamber 120 is free from a wafer contamination problem, and may thus be made of a metal material. The external chamber 120 may have a protective area 125 for accommodating the internal chamber 110. The external chamber 120 may also have a door (not shown) disposed at its lower portion. The door may descend together with the door of the internal chamber 110, and open the protective area 125.

The gas supply unit 130 may supply gas to the chamber 110 or 120. The gas supply unit 130 may have a gas supplier 131 communicating with the utility of a semiconductor factory. The gas supplier 131 may supply source gas, purge gas, and atmospheric gas to the internal chamber 110, specifically the processing area 115. The source gas may include, for example, oxygen gas, water vapor, ammonia gas, ethylene gas, or propylene gas. The purge gas may include, for example, nitrogen gas, argon gas, or helium gas. The atmospheric gas may include, for example, hydrogen gas, deuterium gas, tritium gas, the nitrogen gas, or the argon gas. The gas supplier 131 may provide, for example, the nitrogen gas, the argon gas, or the helium gas, as a protective gas for the protective area 125. The protective gas may be selected as a gas of the same type as the purge gas. The protective gas injected in the protective area 125 may specifically fill a region of the protective area 125 that excludes the internal chamber 110. These gases may respectively be injected into the processing area 115 or the protective area 125 through an internal gas line 133 or an external gas line 135.

The source gas, the purge gas, and the atmospheric gas may be supplied to the internal chamber 110, to form a high-pressure reaction pressure higher than the atmospheric pressure, for example, several atmospheres to tens of atmospheres. In the specification, a "high pressure" is used to refer to a pressure higher than the atmospheric pressure (1 ATM). The protective gas may be supplied to the external chamber 120 to form a protective pressure that has a certain relationship to the reaction pressure. For example, the protective pressure may be set to be slightly higher than the reaction pressure to thus prevent the source gas, the purge gas, and the atmospheric gas from leaking from the processing area 115. The protective pressure may be adjusted in conjunction with the reaction pressure in compliance with its relationship with the reaction pressure.

The gas exhaust unit 140 may exhaust the source gas, the purge gas, the atmospheric gas, and the protective gas from the chamber 110 or 120. A gas exhaust pipe 141 may be connected to the top of the internal chamber 110 to exhaust the source gas, the purge gas or the atmospheric gas from the internal chamber 110, specifically the processing area 115. A gas exhaust 143 may be installed at the gas exhaust pipe 141. The gas exhaust 143 may be a valve that regulates the exhaust of the source gas, the purge gas, or the atmospheric gas.

A gas exhaust pipe 145 communicating with the external chamber 120 and a gas exhaust 147 installed thereat may be provided to also exhaust the protective gas from the external chamber 120, specifically from the protective area 125. These gas exhaust pipes 141 and 145 may communicate with each other, and the source gas and the atmospheric gas may thus be exhausted while diluted in the protective gas.

A control operation of the first high-pressure wafer processing module 100 is described with reference to FIG. 3. FIG. 3 is a block diagram for describing the control operation of the first high-pressure wafer processing module 100 in FIG. 1.

Referring to this drawing (and FIG. 2), the first high-pressure wafer processing module 100 may further include a heating unit 150, a detection unit 160, a control unit 170, and a storage unit 180 in addition to the gas supply unit 130 and the like, described above.

The heating unit 150 may include the above-mentioned heater. The heater may be disposed in the protective area 125. The heater may heat the source gas, the purge gas, or the atmospheric gas to reach a reaction temperature.

The detection unit 160 may detect an environment of the chamber 110 or 120. The detection unit 160 may include a pressure gauge 161 and a temperature gauge 165. The pressure gauge 161 and the temperature gauge 165 may be installed at each of the chambers 110 and 120.

The control unit 170 may control the gas supply unit 130, the gas exhaust unit 140, or the like. The control module 170 may control the gas supply unit 130 or the like based on a detection result of the detection unit 160.

The storage unit 180 may store data, programs, or the like that the control unit 170 may refer to for the control. The storage unit 180 may include at least one type of storage medium among a flash memory, a hard disk, a magnetic disk, and an optical disk.

According to this configuration, the control unit 170 may control the gas supply unit 130 or the like to perform the high-pressure wafer processing method according to an embodiment of the present invention.

In detail, the control unit 170 may control an operation of the gas supply unit 130 based on a pressure in the chamber 110 or 120 that is acquired through the pressure gauge 161. By the operation of the gas supply unit 130, the internal chamber 110 may be filled with the source gas, the purge gas, or the atmospheric gas at the reaction pressure. The external chamber 120 may be filled with the protective gas at the protective pressure.

The control unit 170 may control an operation of the heating unit 150 based on a temperature of the chamber 110 or 120 that is acquired through the temperature gauge 165. By the operation of the heating unit 150, the source gas, the purge gas, or the atmospheric gas may reach the reaction temperature.

The control unit 170 may also control an operation of the gas exhaust unit 140 based on the pressure in the chamber 110 or 120 that is acquired through the pressure gauge 161. By the operation of the gas exhaust unit 140, the source gas, the purge gas, or the atmospheric gas may be exhausted from the internal chamber 110. The protective gas may be exhausted from the external chamber 120.

A specific configuration of the second high-pressure wafer processing module 200 may be generally the same as that of the first high-pressure wafer processing module 100. Accordingly, the description omits a description of the specific configuration of the second high-pressure wafer processing module 200. If necessary, a specific component of the second high-pressure wafer processing module 200 may be referred to by a similar reference numeral as a corresponding component of the first high-pressure wafer processing module 100.

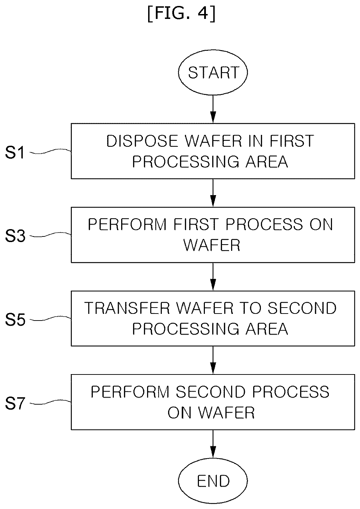

A specific wafer processing method using the first high-pressure wafer processing module 100 described above is described with reference to FIGS. 4 to 6.

FIG. 4 is a flowchart showing the high-pressure wafer processing method according to an embodiment of the present invention.

Referring to this drawing (and FIGS. 1 to 3), the wafer may be disposed in the first processing area 115 of the first high-pressure wafer processing module 100 (S1). The wafer may be, for example, a silicon wafer. The wafer may have an insulation film or a metal oxide film, or may be a bare wafer itself.

A first process may be performed on the wafer in the first processing area 115 (S3). The first process may be any one of the high-pressure oxidation (HPO), the high-pressure nitridation (HPN), the high-pressure carbon doping (HPCD), and the high-pressure annealing (HPA).

After completing the first process, the wafer may be transferred to a second processing area 215 of the second high-pressure wafer processing module 200 (S5). The wafer may be transferred in the accommodation space 350. Accordingly, the wafer may not be exposed to the atmosphere. In addition, a queue time for the wafer to be loaded into the second processing area 215 may not be long.

A second process may be performed on the wafer in the second processing area 215 (S7). The second process may be another one of the high-pressure oxidation (HPO), the high-pressure nitridation (HPN), the high-pressure carbon doping (HPCD), and the high-pressure annealing (HPA).

The reaction pressure in each of the first process and the second process may be a pressure (high pressure) higher than the atmospheric pressure. Accordingly, the wafer may thus sequentially undergo a high-pressure treatment in the first process and the second process.

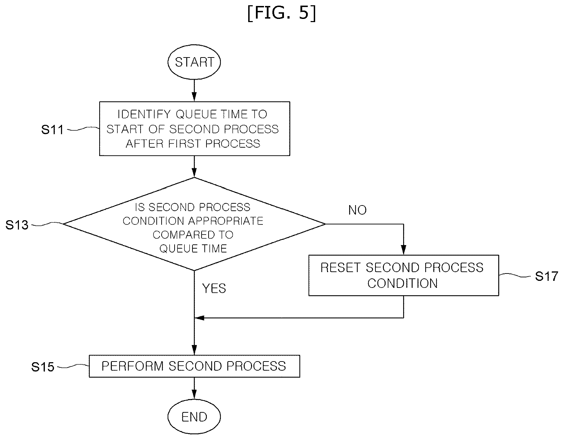

A specific proceeding method of the second process is described with reference to FIG. 5. FIG. 5 is a flowchart showing the specific proceeding method of the second process.

Referring further to this drawing, a control unit 270 may identify the queue time from the completion of the first process to start of the second process (S11).

The control unit 270 may determine whether a preset process condition of the second process is appropriate compared to the identified queue time (S13). The process condition may be, for example, the reaction pressure.

When the process condition is appropriate, the control unit 270 may confirm the process condition. The control unit 270 may allow the second process to be performed under the confirmed process condition (S15).

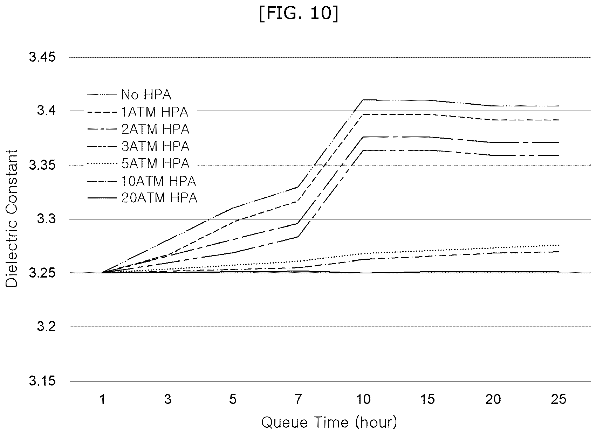

When the process condition is not appropriate, the control unit 270 may reset the process condition of the second process by reflecting the queue time (S17). For example, when the queue time becomes longer than expected, the control unit 270 may reset the reaction pressure to be higher than a preset value (see FIG. 10). The control unit 270 may confirm the reset process condition and allow the second process to be performed under the confirmed process condition (S15).

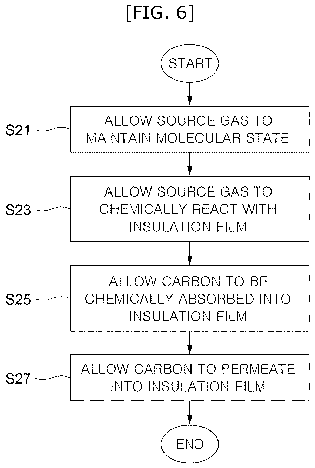

The description describes a mechanism of action of the high-pressure carbon doping (HPCD) among the high-pressure oxidation (HPO), the high-pressure nitridation (HPN), the high-pressure carbon doping (HPCD), and the high-pressure annealing (HPA), with reference to FIG. 6. FIG. 6 is a flow chart for describing the mechanism of action of high-pressure carbon doping (HPCD). The description is provided based on the fact that the high-pressure carbon doping (HPCD) is performed in the second high-pressure wafer processing module 200.

Referring to this drawing (and FIGS. 2 and 3), the wafer having the insulation film may be disposed in the second processing area 215. The insulation film may be, for example, a silicon oxide film (SiO) formed by the high-pressure oxidation (HPO) in the first processing area 115. The atmospheric gas may be supplied to the second processing area 215 to cause a pressure in the second processing area 215 to reach the reaction pressure. In order for a temperature in the second processing area 215 to reach the reaction temperature, the second processing area 215 may be heated.

The source gas for carbon doping may use the ethylene gas or the propylene gas, as described above. The source gas may maintain its molecular state in the second processing area 215 (S21). For this purpose, the reaction temperature may be maintained below a thermal decomposition temperature of the source gas. In detail, the reaction temperature of the ethylene gas or the propylene gas may be determined within a range of 400 °C to 600 °C.

The source gas may chemically react with the insulation film in the molecular state (S23). This chemical reaction may be possible because the source gas is maintained in the molecular state by the reaction temperature.

Carbon in the source gas may be absorbed into the insulation film by the chemical reaction between the source gas and the insulation film, specifically by the chemical absorption (S25).

Carbon may permeate deeply into the insulation film by a pressing force (S27). The pressing force may refer to a force generated by the reaction pressure. To form the pressing force, the reaction pressure may become the high pressure.

The first process and the second process may be performed in various combinations. Hereinafter, the description describes content of each combination, the process condition, or the like based on an experimental result.

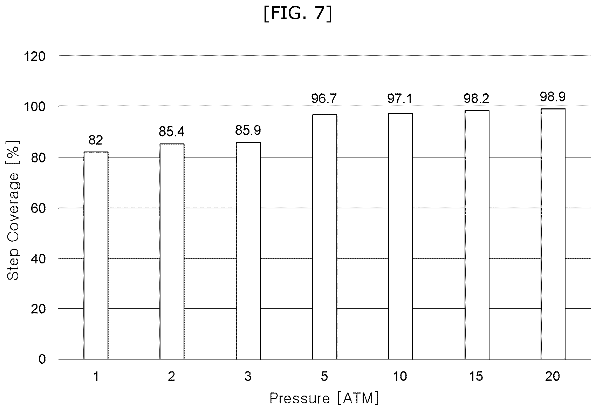

The description describes a combination of the high-pressure oxidation (HPO) as the first process and the high-pressure carbon doping (HPCD) as the second process with reference to FIGS. 7 to 10.

FIG. 7 is a comparative graph of step coverage of the insulation film manufactured by the high-pressure oxidation (HPO).

Referring to this drawing, as the first process, the high-pressure oxidation (HPO) is performed using a wet oxidation method. The insulation film (SiO) by the high-pressure oxidation (HPO) is formed to have a thickness of 10 nm. As the source gas for oxidation, 20 sccm of water vapor is supplied to the first processing area 115, and the reaction pressure is adjusted within a range of 1 ATM to 20 ATM. A solution used for wet etching is a mixture of 1 part by weight of hydrofluoric acid per 100 parts by weight of pure water.

The reaction temperature of the high-pressure oxidation (HPO) may be determined within a range of 400°C to 950°C. In this experiment, the reaction temperature is set to 500°C. The reaction temperature may be determined to be 600°C or below due to the high reaction pressure. The reaction temperature of the high-pressure oxidation (HPO) is relatively low compared to a reaction temperature of a general vacuum deposition process.

Again, note the reaction pressure. When the reaction pressure is increased from 1 ATM to 20 ATM, the step coverage of the insulation film is also increased.

For example, the step coverage of the insulation film is 82% at 1 ATM, and 85.4% at 2 ATM. The step coverage is increased to 85.9% at 3 ATM, which is only a minimal increase.

However, the step coverage is significantly increased at 5 ATM to thus reach 96.7%. As the first pressure is increased to 10 ATM, 15 ATM, or 20 ATM, the step coverage becomes 97.1%, 98.2%, or 98.9%.

Considering such a result, it is preferable in terms of the step coverage that the reaction pressure is 5 ATM or more. The reaction pressure is required to be set to 20 ATM in order to acquire the best step coverage.

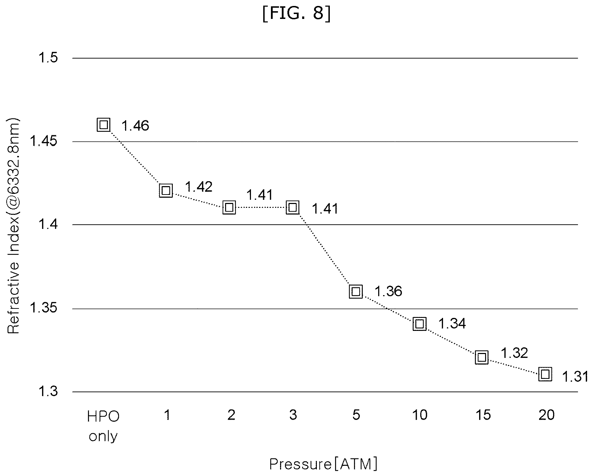

FIG. 8 is a comparative graph of a refractive index of the insulation film manufactured by the high-pressure oxidation (HPO) and the high-pressure carbon doping (HPCD).

Referring to this drawing, as the second process, the high-pressure carbon doping (HPCD) is performed on the insulation film formed by the previous high-pressure oxidation (HPO) (at 20 ATM). As the source gas for carbon doping, 5K sccm of ethylene gas is supplied to the second processing area 215, and the reaction pressure is adjusted within a range of 1 ATM to 20 ATM.

The reaction temperature of the high-pressure carbon doping (HPCD) may be determined within the range of 400°C to 950°C. In this experiment, the reaction temperature is set to 400°C. The reaction temperature may be determined to be 600°C or below because the high reaction pressure acts.

Again, note the change in the reaction pressure. Compared to the insulation film (HPO only) that undergoes only the high-pressure oxidation (HPO), the refractive index of the insulation film doped with carbon even at 1 ATM is decreased. As the reaction pressure is increased from 1 ATM to 20 ATM, the refractive index shows an overall decrease trend.

Considering this trend, the higher the reaction pressure, the more preferable it is. At 20 ATM, the refractive index reaches its lowest value of 1.31. In addition, the refractive index is significantly decreased at 5 ATM. Considering these points, it is preferable that the reaction pressure of the high-pressure carbon doping (HPCD) is determined within a range of 5 ATM to 20 ATM.

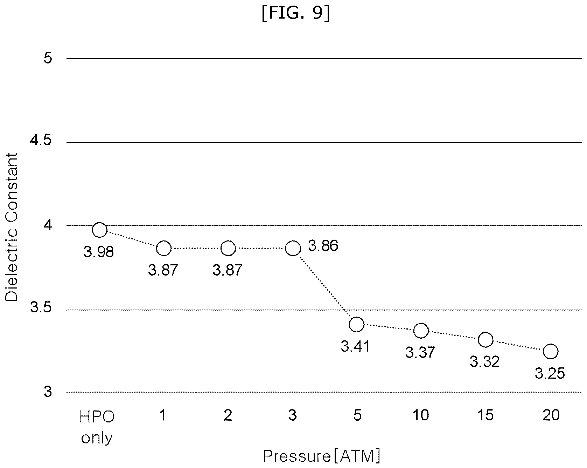

FIG. 9 is a comparative graph of a dielectric constant of the insulation film manufactured by the high-pressure oxidation (HPO) and the high-pressure carbon doping (HPCD).

Referring to this drawing, a change in the dielectric constant of the insulation film has a similar tendency to the change in the refractive index described above.

In detail, compared to the insulation film (HPO only) that undergoes only the high-pressure oxidation (HPO), the dielectric constant of the insulation film doped with carbon even at 1 ATM is also decreased. As the reaction pressure is increased from 1 ATM to 20 ATM, the dielectric constant also shows the overall decrease trend.

Considering this trend, the higher the reaction pressure, the more preferable it is. At 20 ATM, the dielectric constant reaches its lowest value of 3.25. In addition, the dielectric constant is significantly decreased at 5 ATM. Considering these points, it is confirmed once again that the reaction pressure of the high-pressure carbon doping (HPCD) is also preferably determined within the range of 5 ATM to 20 ATM.

FIG. 10 is a comparative graph showing a change in the dielectric constant of the insulation film doped by additionally performing the high-pressure annealing (HPA) thereon.

Further referring to this drawing (and FIGS. 2 and 3), the high-pressure annealing (HPA) may be further performed using an in-situ method in the second processing area 215 after performing the high-pressure carbon doping (HPCD) in the second processing area 215. The high-pressure annealing (HPA) is performed on the insulation film doped by the high-pressure carbon doping (HPCD) (at 20 ATM). The high-pressure annealing (HPA) may be considered to be included in the second process.

In order to perform the high-pressure annealing (HPA) by using the in-situ method, a purge process may be performed between the high-pressure carbon doping (HPCD) and the high-pressure annealing (HPA). The reaction temperature and reaction pressure in the purge process may be maintained to be the same as in the previous high-pressure carbon doping (HPCD) process. The control unit 270 may control a gas exhaust unit 240 and a gas supply unit 230 together to thus allow the purge gas to be supplied to the second processing area 215 and the source gas to be purged and exhausted from the second processing area 215. A time required for the purge process may be shorter than a time required for the high-pressure carbon doping (HPCD) process.

For the high-pressure annealing (HPA), the atmospheric gas for annealing, for example, the hydrogen gas, is supplied to the second processing area 215. The reaction pressure of the atmospheric gas is controlled within the range of 1 ATM to 20 ATM. The reaction temperature of the high-pressure annealing (HPA) is maintained to be 400°C, which is the same as the reaction temperature in the purge process. The reaction temperature of the high-pressure annealing (HPA) may also be determined within the range of 400°C to 950°C, and is determined to be 400°C in this experiment. The reaction temperature may be determined to be 600°C or below because the high reaction pressure acts.

Again, note the change in the reaction pressure. First, the dielectric constant of the insulation film generally tends to be increased as the queue time is increased. As the reaction pressure is increased from 1 ATM to 20 ATM, an amount of increase in the dielectric constant, which is caused by the increase in the queue time, becomes smaller.

Considering this tendency, the higher the reaction pressure, the more preferable it is. At 20 ATM, the dielectric constant remains almost unchanged and remains at 3.25 despite the change in the queue time. In addition, the change in dielectric constant is significantly decreased at 5 ATM. Considering these points, it is preferable that the reaction pressure of the high-pressure annealing (HPA) is determined within the range of 5 ATM to 20 ATM.

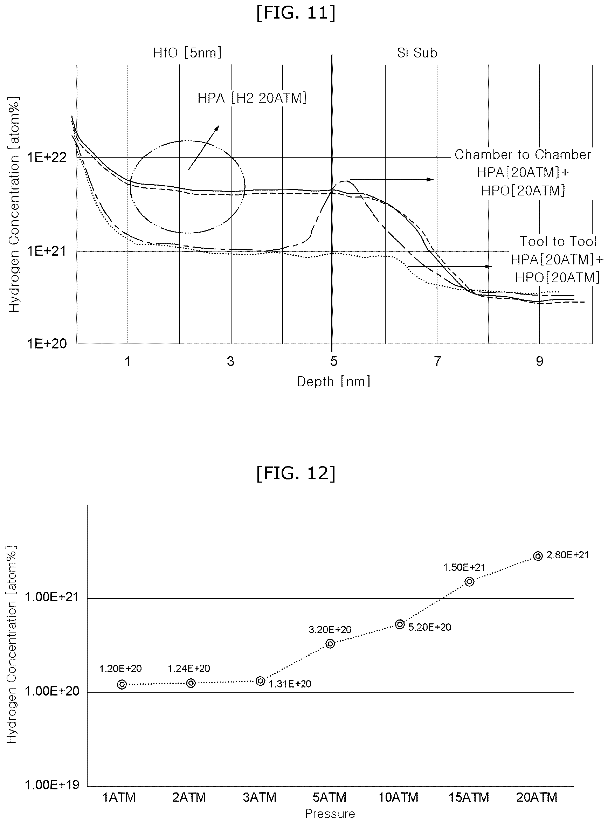

The description describes a combination of the high-pressure annealing (HPA) as the first process and the high-pressure oxidation (HPO) as the second process with reference to FIGS. 11 and 12.

FIG. 11 is a comparative graph of a hydrogen concentration of the wafer that sequentially undergoes the high-pressure annealing (HPA) and the high-pressure oxidation (HPO).

Referring to this drawing (and FIG. 2), the wafer has a 5 nm thick hafnium oxide film (HfO). The hafnium oxide film is formed using atomic layer deposition (ALD) equipment under process conditions of 1 torr and 450°C.

The high-pressure annealing (HPA) is performed on the wafer at process conditions of 20 ATM and 400°C. As the atmospheric gas, 5 Ksccm of hydrogen gas is supplied to the first processing area 115. Two wafers are prepared.

When only the high-pressure annealing (HPA) is performed thereon, the hydrogen concentrations of both the wafers tend to be decreased from the hafnium oxide film to a silicon substrate. In detail, the hydrogen concentration is decreased approximately in a step shape near a surface of the hafnium oxide film and after an interface (of 5 nm depth) between the hafnium oxide film and the substrate.

The high-pressure oxidation (HPO) is additionally performed on both the wafers. The high-pressure oxidation (HPO) is performed on one of the two wafers by using a chamber to chamber method according to this embodiment, and performed on the other by using a tool-to-tool method, respectively. In both the methods, the high-pressure oxidation (HPO) is performed under the process conditions of 20 ATM and 450°C. 20 sccm of water vapor as the source gas is supplied to the second processing area 215.

In the case of the tool-to-tool method, a graph form of the hydrogen concentration is similar to that of a case where only the high-pressure annealing (HPA) is performed. However, the hydrogen concentration of the former has a significantly lower value than that of the latter, especially in a hafnium oxide film region.

In contrast, in the chamber-to-chamber method, the hydrogen concentration has an increased value before and after the interface. These results are understood to represent that hydrogen in the hafnium oxide film is moved to the interface.

FIG. 12 is a comparative graph of the hydrogen concentration at the interface, caused by the high-pressure annealing (HPA) and the high-pressure oxidation (HPO).

Referring further to this drawing, shown is a change in the hydrogen concentration at the interface based on the reaction pressure when using the chamber-to-chamber method. The reaction pressure is adjusted from 1 ATM to 20 ATM.

As the reaction pressure is increased from 1 ATM to 20 ATM, the hydrogen concentration at the interface is generally increased. Considering this trend, the higher the reaction pressure, the more preferable it is.

At 20 ATM, the hydrogen concentration reaches its maximum of 2.80E+21atom%. In addition, the hydrogen concentration is significantly increased at 5 ATM. Considering these points, it is preferable that the reaction pressure of the high-pressure oxidation (HPO) is determined within the range of 5 ATM to 20 ATM.

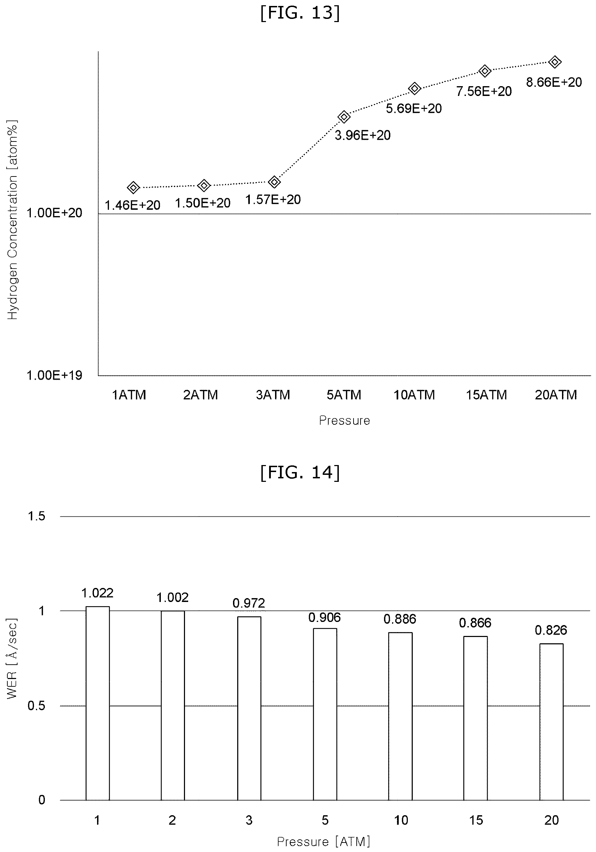

The description describes a combination of the high-pressure annealing (HPA) as the first process and the high-pressure nitridation (HPN) as the second process with reference to FIG. 13. FIG. 13 is a comparative graph of the hydrogen concentration at the interface, caused by the high-pressure annealing (HPA) and the high-pressure nitridation (HPN).

Referring to this drawing (and FIG. 2), the wafer has the 5nm thick hafnium oxide film (HfO), which is the same as in the previous embodiment. The high-pressure annealing (HPA) is also performed on the wafer in the first processing area 115 under the same process conditions as those in the previous embodiment.

As the second process, the high-pressure nitridation (HPN) is performed on the wafer. As the source gas for nitridation, 2K sccm of ammonia gas is supplied to the second processing area 215, and the reaction pressure is adjusted within the range of 1 ATM to 20 ATM.

The reaction temperature may be determined within the range of 400°C to 950°C, and is determined to be 450°C in this experiment. The reaction temperature may be determined to be 600°C or below because the high reaction pressure acts.

Again, note the reaction pressure. As the reaction pressure is increased from 1 ATM to 20 ATM, the hydrogen concentration at the interface is generally increased. Considering this trend, the higher the reaction pressure, the more preferable it is.

At 20 ATM, the hydrogen concentration reaches its maximum of 8.66E+20atom%. In addition, the hydrogen concentration is significantly increased at 5 ATM. Considering these points, it is preferable that the reaction pressure of the high-pressure nitridation (HPN) is determined within the range of 5 ATM to 20 ATM.

The description describes a combination of the high-pressure oxidation (HPO) as the first process and the high-pressure annealing (HPA) as the second process with reference to FIG. 14. FIG. 14 is a comparative graph of a wet etch rate of the insulation film by the high-pressure oxidation (HPO) and the high-pressure annealing (HPA).

Referring to this drawing, as the first process, the high-pressure oxidation (HPO) is performed using the wet oxidation method under the same process conditions as those in the previous embodiment. As the second process, the high-pressure annealing (HPA) is also performed under the same process conditions as those in the previous embodiment.

The reaction pressure of the high-pressure annealing (HPA) is adjusted from 1 ATM to 20 ATM. When the reaction pressure is increased from 1 ATM to 20 ATM, the wet etch rate of the insulation film (SiO) (at 20 ATM) generated by the high-pressure oxidation (HPO) tends to be decreased.

When the reaction pressure is 1 ATM to 2 ATM, the wet etch rate is higher than 1 Å/sec. To acquire a wet etch rate lower than 1 Å/sec, the reaction pressure needs to be set to 3 ATM or more. In detail, the wet etch rate at 3 ATM is 0.972 Å/sec, which is within a desired range.

Further, as the reaction pressure is increased to 5 ATM, 10 ATM, 15 ATM, or 20 ATM, the wet etch rate becomes 0.906 Å/sec, 0.886 Å/sec, 0.866 Å/sec, or 0.826 Å/sec.

Considering these results, it is preferable in terms of the wet etch rate that the reaction pressure of the high-pressure annealing (HPA) is 3 ATM or more. To acquire the best wet etch rate, the reaction pressure may be set to 20 ATM.

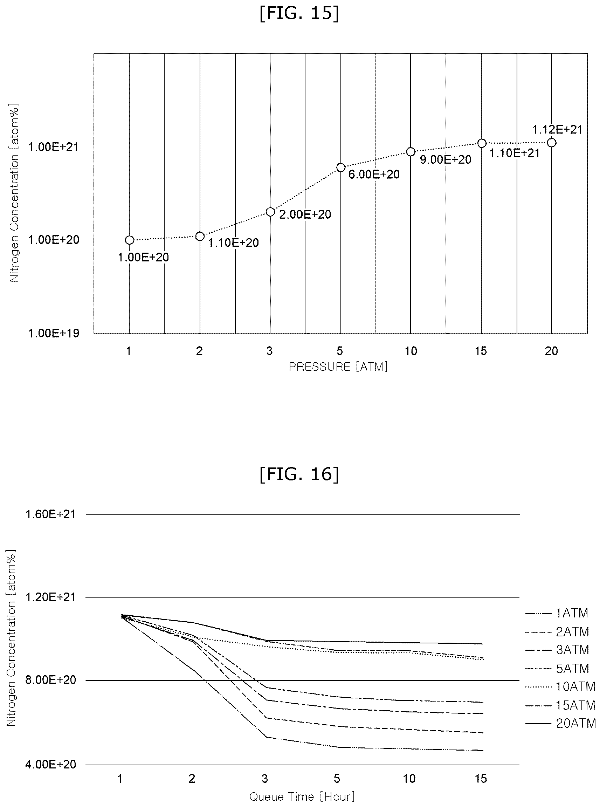

The description describes a combination of the high-pressure nitridation (HPN) as the first process and the high-pressure annealing (HPA) as the second process with reference to FIGS. 15 and 16.

FIG. 15 is a comparative graph of a nitrogen concentration of the hafnium oxide film by the high-pressure nitridation (HPN).

Referring to this drawing, as the first process, the high-pressure nitridation (HPN) is performed under the same process conditions as those in the previous embodiment to produce the hafnium oxide film. In that case, the reaction pressure is adjusted from 1 ATM to 20 ATM.

As the reaction pressure is increased from 1 ATM to 20 ATM, the nitrogen concentration of the hafnium oxide film is generally increased. Here, the nitrogen concentration is the average concentration within a thickness range of the hafnium oxide film.

Considering this trend, the higher the reaction pressure, the more preferable it is. At 20 ATM, the nitrogen concentration reaches its maximum of 1.12E+21atom%. In addition, the nitrogen concentration is significantly increased at 5 ATM. Considering these points, it is preferable that the reaction pressure of the high-pressure nitridation (HPN) is determined within the range of 5 ATM to 20 ATM.

FIG. 16 is a comparative graph showing a change in the nitrogen concentration of the hafnium oxide film, caused by the high-pressure nitridation (HPN) and the high-pressure annealing (HPA).

Referring to this drawing, as the second process, the high-pressure annealing (HPA) is also performed under the same process conditions as those in the previous embodiment. The reaction pressure of the high-pressure annealing (HPA) is adjusted from 1 ATM to 20 ATM.

First, it may be seen that the nitrogen concentration of the hafnium oxide film is generally decreased as the queue time is increased. As the reaction pressure is increased from 1 ATM to 20 ATM, an amount of decrease in the nitrogen concentration, caused by the increase in the queue time, becomes smaller. Considering this trend, the higher the reaction pressure, the more preferable it is.

At 20 ATM, the amount of decrease in the nitrogen concentration is the smallest despite the change in the queue time. In addition, the amount of decrease in the nitrogen concentration becomes significantly smaller at 10 ATM. Considering these points, it is preferable that the reaction pressure of the high-pressure annealing (HPA) is determined within a range of 10 ATM to 20 ATM.

The high-pressure wafer processing method using a dual high-pressure wafer processing facility as described above is not limited to the configuration and operation method in the embodiments described above. The embodiments described above may be variously modified by selective combinations of all or some of the respective embodiments.

### [Industrial Applicability]

The present invention has potential industrial application in a field of high-pressure wafer processing using a dual high-pressure wafer processing facility.

## Claims

1. A high-pressure wafer processing method using a dual high-pressure wafer processing facility, the method comprising:
disposing a wafer in a first processing area of a first high-pressure wafer processing module;
performing a first process, which corresponds to one among high-pressure oxidation, high-pressure nitridation, high-pressure carbon doping, and high-pressure annealing, on the wafer in the first processing area;
transferring the wafer to a second processing area of a second high-pressure wafer processing module; and
performing a second process, which corresponds to another one among the high-pressure oxidation, the high-pressure nitridation, the high-pressure carbon doping, and the high-pressure annealing, on the wafer in the second processing area,
wherein the first high-pressure wafer processing module and the second high-pressure wafer processing module are disposed in one accommodation space,
the wafer is transferred from the first processing area to the second processing area, in the accommodation space, and
the first process and the second process are performed at a reaction pressure higher than an atmospheric pressure.

2. The method of claim 1, wherein the reaction pressure of the high-pressure oxidation, the high-pressure nitridation, or the high-pressure carbon doping is determined within a range of 5 ATM to 20 ATM.

3. The method of claim 1, wherein the reaction pressure of the high-pressure annealing is determined within a range of 3 ATM to 20 ATM.

4. The method of claim 1, wherein a reaction temperature of the high-pressure oxidation, the high-pressure nitridation, or the high-pressure annealing is determined within a range of 400°C to 600°C.

5. The method of claim 1, wherein source gas for each of the high-pressure oxidation and the high-pressure nitridation includes any one of oxygen gas, water vapor, and ammonia gas.

6. The method of claim 1, wherein the high-pressure carbon doping is performed at a reaction temperature below a thermal decomposition temperature of source gas for carbon doping, thus causing the source gas to chemically react with an insulation film of the wafer in its molecular state.

7. The method of claim 6, wherein the reaction temperature of the high-pressure carbon doping is determined within a range of 400°C to 600°C.

8. The method of claim 6, wherein the source gas for carbon doping includes any one of ethylene gas and propylene gas.

9. The method of claim 1, further comprising performing the high-pressure annealing on the wafer by using an in-situ method after performing any one of the high-pressure oxidation, the high-pressure nitridation, and the high-pressure carbon doping.

10. The method of claim 9, further comprising performing a purge between any one of the high-pressure oxidation, the high-pressure nitridation, the high-pressure carbon doping, and the high-pressure annealing,
wherein the purge is performed while maintaining the reaction pressure and a reaction temperature in a previous process.

11. The method of claim 1, wherein each of the first high-pressure wafer processing module and the second high-pressure wafer processing module further includes a protective area accommodating any one of the first processing area and the second processing area and maintained at a protective pressure, and
the protective pressure in the protective area is adjusted in conjunction with the reaction pressure to be higher than the reaction pressure.

12. The method of claim 1, wherein the accommodation space is maintained at a pressure higher than the atmospheric pressure.

13. The method of claim 1, wherein the transferring of the wafer to the second processing area of the second high-pressure wafer processing module includes unloading the wafer from the first processing area and then loading the wafer into the second processing area without a cooling process.

14. The method of claim 1, wherein the performing of the second process, which corresponds to another one among the high-pressure oxidation, the high-pressure nitridation, the high-pressure carbon doping, and the high-pressure annealing, on the wafer in the second processing area includes confirming a process condition by considering a queue time after completing the first process.

15. The method of claim 1, wherein the first process is the high-pressure oxidation, the second process is the high-pressure carbon doping, and
the reaction pressure of the high-pressure oxidation and the high-pressure carbon doping is determined within a range of 5 ATM to 20 ATM.

16. The method of claim 15, wherein the second process further includes the high-pressure annealing performed using an in-situ method after the high-pressure carbon doping, and
the reaction pressure of the high-pressure annealing is determined within the range of 5 ATM to 20 ATM.

17. The method of claim 1, wherein the first process is the high-pressure annealing, the second process is the high-pressure oxidation, and
the reaction pressure of the high-pressure annealing and the high-pressure oxidation is determined within a range of 5 ATM to 20 ATM.

18. The method of claim 1, wherein the first process is the high-pressure annealing, the second process is the high-pressure nitridation, and
the reaction pressure of the high-pressure annealing and the high-pressure nitridation is determined within a range of 5 ATM to 20 ATM.

19. The method of claim 1, wherein the first process is the high-pressure oxidation, the second process is the high-pressure annealing,
the reaction pressure of the high-pressure oxidation is determined within a range of 5 ATM to 20 ATM, and
the reaction pressure of the high-pressure annealing is determined within a range of 3 ATM to 20 ATM.

20. The method of claim 1, wherein the first process is the high-pressure nitridation, the second process is the high-pressure annealing,
the reaction pressure of the high-pressure nitridation is determined within a range of 5 ATM to 20 ATM, and
the reaction pressure of the high-pressure annealing is determined within a range of 10 ATM to 20 ATM.
